(19) Europäisches Patentamt
European Patent Office
Office européen des brevets

(11) EP 3 584 930 A1

(12) EUROPEAN PATENT APPLICATION
published in accordance with Art. 153(4) EPC

(43) Date of publication:
25.12.2019 Bulletin 2019/52

(51) Int Cl.:
$H03K\ 3/53^{(2006.01)}$

(21) Application number: 17896954.9

(86) International application number:
PCT/RU2017/000829

(22) Date of filing: 07.11.2017

(87) International publication number:
WO 2018/151622 (23.08.2018 Gazette 2018/34)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 14.02.2017 RU 2017104769

(71) Applicant: Efanov, Mikhail Vladimirovich
St. Petersburg 191002 (RU)

(72) Inventors:
• EFANOV, Vladimir Mikhailovich
St.Petersburg 191002 (RU)
• KRASNOV, Arseny Vadimovich
St. Petersburg 194156 (RU)
• EFANOV, Mikhail Vladimirovich
St.Petersburg 191002 (RU)

(74) Representative: van Trier, Norbertus Henricus
Gerardus
Octrooibureau Vriesendorp & Gaade B.V.
Koninginnegracht 19
2514 AB Den Haag (NL)

(54) **HIGH-VOLTAGE PULSE GENERATOR**

(57) The invention relates to the field of high-voltage pulse technology. A generator comprises a charging circuit, a limiter and a load. The charging circuit is incorporated in a Marx generator, which also contains NI links consisting of switches having capacitors, which switches are connected by an Arkadyev-Marx voltage multiplication cascade circuit. Between the last switch of the Marx generator and the common bus, a choke and a fast-recovery diode having a short reverse recovery time are connected in series. The limiter includes the charging circuit and N2 links consisting of drift diodes and capacitors connected in series. The last drift diode from the N2 links of the limiter is connected to the connection point of the load and the fast-recovery diode with a short reverse recovery time. The parameters of the charging circuits of the Marx generator and of the limiter and the number of their links N1 and N2 must satisfy set conditions. The technical result is increased efficiency of the generator.

Figure 1

EP 3 584 930 A1

**Description**

FIELD OF THE INVENTION

The invention relates to the art of high-voltage pulse technology and can find application in the generation of rectangular short high-voltage pulses.

BACKGROUND OF THE INVENTION

A high-voltage rectangular pulse generator is known, which includes storage capacitors, surge arresters, charging resistors and a power source connected by Arcadyev-Marx scheme (see RU Patent No. 2102834, IPC H03K 3/53, 1988). The disadvantages of this device are low efficiency and inability to adjust the duration of the output voltage pulse. The closest in technical essence to the claimed solution is a high power pulse-width modulator including a charging circuit, an energy storage unit, a semiconductor storage diode having step recovery characteristics, a load (see US Patent No. 3486043, IPC H03K 3/33, H03K 7/08, 1969).

This device uses the first switch for connecting the diode and the storage means and second switch for connecting the diode to the load. The duration of the output pulse is determined by the charge accumulated in the diode, the recombination rate of the charge carriers in the diode and the on-delay of the second switch. The duration is adjusted by changing the on-delay of the second switch. The presence of the second switch leads to losses and requires a complex control system. The duration of the output pulse in this circuit depends significantly on the time of charge carrier recombination in the storage diode, which in turn depends strongly on temperature.

This device requires the use of a high constant voltage source, which leads to increased dimensions of the device due to raised requirements for electrical insulation. Thus, the disadvantages of this device are low efficiency, large dimensions, control complexity and significant dependence of the output pulse duration on temperature, which reduces the stability of the device.

SUMMARY OF THE INVENTION

The technical result of the claimed solution involves increasing the generator efficiency up to 70% and higher, with simultaneous high reliability of the device operation when obtaining rectangular high voltage pulses with adjustable duration and amplitude with high stability and in a wide range.

In order to achieve this technical result, in a high-voltage pulse generator for receiving rectangular voltage pulses, including a charging circuit, a limiter and a load, according to the invention, the charging circuit is brought into the Marx generator, also containing $N_1$-links consisting of switches with capacitors, connected in Arkadyev-Marx stage voltage multiplication circuit, with the first-link Marx generator capacitor connected to the common bus, and the charging circuit of the Marx generator connected to a common bus and to the points of connection of the capacitors and switches in each of the $N_1$-links, herewith the choke and the diode with short reverse recovery time are connected in series between the last switch of the Marx generator and the common bus, while the limiter includes a charging circuit and $N_2$-links consisting of drift diodes and capacitors connected in series, with the capacitor of the first link limiter connected to the common bus, and the limiter charging circuit connected to the common bus and to the points of connection of capacitors and drift diodes in each link of the $N_2$-links, herewith the last drift diode of $N_2$-links of the limiter is connected to the point of connection of the load and the pulse diode with short reverse recovery time, while the parameters of the charging circuits of the Marx generator and the limiter and the number of their links $N_1$ and $N_2$ shall satisfy the following condition:

$$U_M > 2 \ (U_o + U_{d1}) \ \text{or} \ N_1 U_1 > 2 \ (N_2 U_2 + N_2 U_d + U_{d1}),$$

where

$U_M = N_1 U_1$ - voltage of the Marx generator;
$N_1$ - the number of links in the Marx generator;
$U_1$ - voltage determined by the Marx generator charging circuit;
$U_o = N_2 U_2 + N_2 U_d$ - voltage of the limiter;
$N_2$ - the number of links in the limiter;
$U_2$ - voltage determined by the limiter charging circuit;
$U_d$ - voltage drop on the drift diode;

$U_{d1}$ - voltage drop on the pulse diode with short reverse recovery time.

The combination in the claimed invention of the Marx generator as a source of high voltage and the limiter in the form of a cascade of drift diodes makes it possible to obtain high-voltage heavy-current rectangular pulses with a range of 100 nanoseconds - 100 microseconds and with an amplitude range of 1 kV - 400 kV. In this case, the edge of the received pulse for the nanosecond range is less than 20 nanoseconds, and for the microsecond range it is less than 100 microseconds.

The claimed invention makes it possible to adjust both the amplitude and the duration of pulses with high stability and in a wide range. In the device, the adjustment of the output pulse duration is achieved by changing the charge accumulated in the drift diode. While the change in this charge, in turn, is achieved by changing the voltage on the capacitors of the Marx generator.

In the case of drift diodes, carrier recombination has little effect on the accumulated charge during the duration of the output pulse. Consequently, the output pulse duration is weakly dependent on the time of recombination of the charge carriers in the diode and, consequently, weakly dependent on the temperature.

The claimed device does not contain a switch connecting the drift diode with the load, which leads to reduced losses and, as a result, increased efficiency, and simplified control.

The claimed device does not contain a source of high constant voltage, which results in its downsizing. Instead of a high constant voltage source, the capacitors of the Marx generator and the limiter are used, which are charged to a low voltage and are connected in series to form a high voltage only for the short time when the voltage pulse is generated on the load.

It follows from the foregoing that the introduced distinctive features affect the indicated technical result and have cause-and-effect relationship with it.

BRIEF DESCRIPTION OF THE DRAWINGS

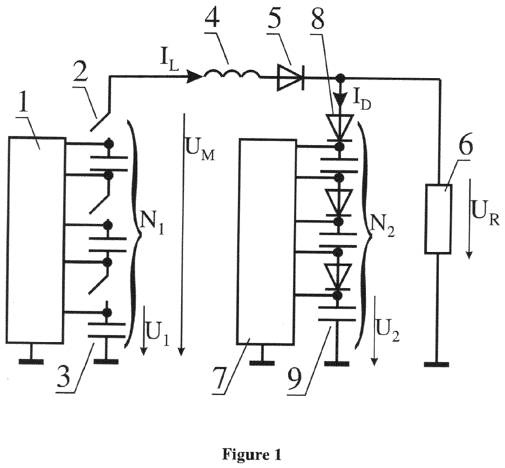

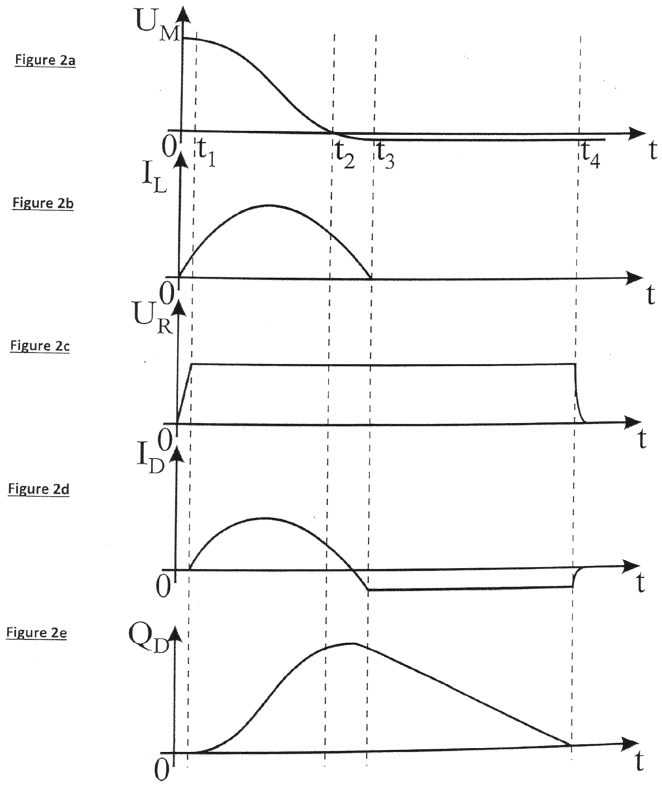

The method is illustrated in the drawings, wherein: Fig. 1 shows the functional circuit of the high-voltage pulse generator; Fig. 2 shows the time graphs of currents, charges and voltages in the circuit, namely: Fig. 2a shows the time graph of the voltage of the Marx generator; Fig. 2b shows the time graph of the current through the choke; Fig. 2c shows the time graph of the voltage on the load; Fig. 2d shows the time graph of the current through the drift diodes; Fig. 2e shows the time graph of the charge accumulated in the drift diodes.

The following positions are used in the drawings: 1 - Marx generator charging circuit; 2 - Marx generator $N_1$-link switches; 3 - Marx generator $N_1$-link capacitors; 4 - choke; 5 - pulse diode with short reverse recovery time; 6 - load; 7 - limiter charging circuit; 8 - drift diodes of the limiter $N_2$-links; 9 - limiter $N_2$-link capacitors.

DETAILED DESCRIPTION OF THE INVENTION

The high-voltage pulse generator includes a high voltage source; for this purpose the Marx generator is used. The Marx generator contains the charging circuit 1 and $N_1$-links, consisting of the switches 2 with the capacitors 3, connected in Arkadyev-Marx stage voltage multiplication circuit. In this case, the capacitor 3 of the first link is connected to the common bus, and the charging circuit 1 is connected to the common bus and to the connection points of the capacitors 3 and the switches 2 in each link. The device also includes the choke 4, the pulse diode 5 with short reverse recovery time and the load 6 connected in series between the last switch 2 of $N_1$-links of the Marx generator and the common bus.

The device includes the limiter comprising the charging circuit 7 and $N_2$-links consisting of series-connected drift diodes 8 and capacitors 9. In this case, the first-link capacitor 9 of the limiter $N_2$-links is connected to the common bus, while the charging circuit 7 is connected to the common bus and the points of connection of capacitors 9 and drift diodes 8 in each link.

The last drift diode 8 of the limiter $N_2$-links is connected to the point of connection of the load 6 and the pulse diode 5 with short reverse recovery time. The high-voltage pulse generator works as follows. At the initial moment, the switches 2 are open, each capacitor 3 of $N_1$-links in the Marx generator is charged to the voltage $U_1$, which is determined by the charging circuit 1 of the Marx generator. Also, each capacitor 9 of the limiter $N_2$-links is charged to the voltage $U_2$ determined by the charging circuit 7 of the limiter. The Marx generator voltage $U_M$ equal to $N_1 U_1$ must satisfy the condition:

$$U_M > 2 \ (U_o + U_{d1}) \ \text{ or } \ N_1 U_1 > 2 \ (N_2 U_2 + N_2 U_d + U_{d1}),$$

where

$U_M = N_1 U_1$ - voltage of the Marx generator;
$N_1$ - the number of links in the Marx generator;
$U_1$ - voltage determined by the Marx generator charging circuit 1;
$U_o = N_2 U_2 + N_2 U_d$ - voltage of the limiter;
$N_2$ - the number of links in the limiter;
$U_2$ - voltage determined by the limiter charging circuit 7;
$U_d$ - voltage drop on the drift diode 8;
$U_{d1}$ - voltage drop on the pulse diode 5 with short reverse recovery time;

The limiter drift diodes 8 are reverse-biased and no current flows through them. On the load 6, the voltage is 0. At the time t = 0, the switches 2 in the Marx generator are closed, the voltage $N_1 U_1$ arises at the point of connection of the choke 4 to the Marx generator. Through the choke 4 and the pulse diode 5 with short reverse recovery time, the current $I_L$ flows into the load 6. The drift diodes 8 of the limiter are closed. Load 6 generates a voltage according to formula $U_R = I_L R$, where $U_R$ - voltage on the load 6; $I_L$ - current through the choke 4; R - resistance of the load 6. The current $I_L$ through the choke 4 has a sinusoidal form, namely:

$$I_L = \left( N_1 \cdot U_1 - N_2 \cdot (U_2 + U_d) - U_{d1} \right) \cdot \sqrt{C/L} \cdot \sin\left( t / \sqrt{L \cdot C} \right)$$

, where $C = C_1 / N_1$ - total capacitance of the capacitors 3 of the Marx generator; L - inductance of the choke 4; t - time variable. The Marx generator voltage $U_M$ also has a sinusoidal form:

$$U_M = \left( N_1 \cdot U_1 - N_2 \cdot (U_2 + U_d) - U_{d1} \right) \cdot \sin\left( t / \sqrt{L \cdot C} + \pi/2 \right) +$$

$$+ N_2 \cdot (U_2 + U_d) + U_{d1}$$

At the time $t = t_1$, the voltage $U_R$ on the load 6 exceeds the sum of the voltage drops on the drift diodes 8 $N_2 U_d$ and the voltage on the capacitors 9 of the $N_2 U_2$ limiter, i.e.

$$U_R > N_2 U_2 + N_2 U_d.$$

Then part of the current $I_L$ of the choke 4 begins to flow through the drift diodes 8 into the capacitors 9 of the limiter. In this case, the capacitors 9 of the limiter have sufficiently large capacitance, and the voltage variation thereon can be neglected.

With further increase in the current $I_L$, the voltage on the load 6 does not change and remains as follows:

$$U_R = N_2 U_2 + N_2 U_d.$$

Thus, at the time $t = t_2$, the following current flows through the drift diodes 8: $I_d = I_L - (N_2 U_2 + N_2 U_d)/R$, where

$I_d$ - current through drift diodes 8. In the drift diodes 8, the charge $Q_d$ accumulates. At the time $t = t_2$, the current $I_L$ of the choke 4 drops to the value: $I_L = (N_2 U_2 + N_2 U_d)/R$. Then the current $I_d$ through the drift diodes 8 changes direction and begins to flow from the Marx generator to the load 6. In this case, the charge $Q_d$ in the drift diodes 8 decreases. At the time $t = t_3$, when the current $I_L$ of the choke 4 drops to 0, the pulse diode 5 with small reverse recovery time transits into a non-conducting state, the current through the drift diodes 8 is: $I_d = (N_2 U_2 + N_2 U_d)/R$.

The current $I_d$ remains constant until the reverse recovery of the drift diodes 8. At the time $t = t_4$, the charge $Q_d$ in the drift diodes 8 decreases to 0, i.e., within the time interval from $t_1$ to $t_4$ $Q_d = \int I_d dt = 0$. In this case, the drift diodes 8 are reverse-recovered and the current $I_d$ through the drift diodes 8 is interrupted. The voltage $U_R$ on the load 6 becomes equal to 0. Thus, a rectangular voltage pulse of duration $t_4$ and amplitude $N_2 U_2 + N_2 U_d$ is formed on the load 6. The pulse amplitude can be adjusted by changing the voltage $U_2$. The pulse duration on the load 6 can be adjusted by

changing the voltage $U_1$. By the time $t = t_3$, the capacitors 3 of the Marx generator are discharged to the total voltage: $U_M = 2 (N_2U_2 + N_2U_d + U_{d1}) - N_1U_1$.

By choosing the voltages $U_1$ and $U_2$ of such values that the following condition is met:

$N_1U_1 > 2 (N_2U_2 + N_2U_d + U_{d1})$, the voltage of the Marx generator $U_M$ is then less than zero, that is, $U_M < 0$ and the pulse diode 5 with short reverse recovery time remains in the closed position until the next closure of the switches 2 of the Marx generator. The current does not flow through the switches 2 and they can be opened and charging of the capacitors 3 to the initial total value $N_1U_1$ can be started. The voltage on the limiter capacitors 9 due to their large capacitance changes little, the voltage continuity over the time much longer than the pulse time is provided by the charging circuit 7 of the limiter.

We give an example of a specific implementation of the high-voltage pulse generator as a proof of the high performance of the claimed device and the achievement of the technical result. For example, the generator of rectangular voltage pulse with adjustable amplitude $U_R$ = 17 - 50 kV on the load R = 500 Ohm and adjustable pulse duration $t_{pul}$ = 5 - 15 $\mu$s. The following parameters of the Marx generator are selected:

$N_1$ = 20 links with the capacitors 3 of capacity $C_1$ = 112 nF, with each capacitor 3 charged to voltage $U_1$ = 5 - 10 kV, depending on the amplitude and duration of the output pulse.

The following parameters of the limiter are selected:

$N_2$ = 10 links with the capacitors 9, with each of them charged to voltage $U_2$ = 1.7 - 5 kV, depending on the amplitude of the output pulse.

The inductance of the choke 4 is chosen to be L = 60 $\mu$H.

The used drift diodes 8 have voltage drops $U_d$ = 36 V, the used diode 5 with short recovery time has a voltage drop $U_{d1}$ = 100 V.

To estimate the efficiency of the generator, we represent the operation of the generator with 50.36 kV amplitude and 5.5 $\mu$s duration. In this case, the voltages on the capacitors 3 and 9 are selected as follows: $U_1$ = 5.05 kV and $U_2$ = 5 kV.

The voltage form on the load 6 is as follows:

$$U_R \;=\; I_LR \;=\; 241*103 \;*\; \sin\,(1.7*106*t)\;\; B,$$

for t = 0..0.1 $\mu$s.

At the time $t_1$ = 0.1 $\mu$s, the voltage $U_R$ on the load 6 exceeds the sum of the voltage drops on the drift diodes 8 and the voltage on the limiter capacitors 9:

$N_2U_2 + N_2U_d$ = 50.36 kV, with further increase in the current $I_L$, the voltage on the load 6 does not change and remains equal to 50.36 kV.

The following current flows through the drift diodes 8:

$$I_d \;=\; I_L \;-\; (N_2U_2 + N_2U_d)/R \;=\; 482 \;*\; \sin\,(1.7*106*t) \;-$$
$$100.7 \hspace{9cm} A,$$

for t = 0.1..1.8 $\mu$s.

By the time $t_2$ = 1.7 $\mu$s, the following charge accumulates in the drift diodes 8: $Q_d = \int I_d dt$ = 400 $\mu$C, for t=0.1..1.7 $\mu$s.

Then the current through the drift diodes 8 changes direction and begins to flow from the Marx generator to the load 6. In this case, the charge $Q_d$ in the drift diodes 8 decreases.

At the time $t_3$ = 1.8 $\mu$s, when the current $I_L$ of the choke 4 drops to 0, the pulse diode 5 with small reverse recovery time transits into a non-conducting state, the current through the drift diodes 8 is equal to:

$$I_d \;=\; (N_2U_2 + N_2U_d)/R \;=\; 100.7 \; A.$$

The current remains constant until the drift diodes 8 are reverse-recovered. At the time $t_4$ = 5.5 $\mu$s, the charge in the drift diodes 8 decreases to 0. In this case, the drift diodes 8 are reverse-recovered and the current through the drift diodes 8 is interrupted. The voltage $U_R$ on the load 6 becomes equal to 0.

Thus, a rectangular voltage pulse with the duration of 5.5 $\mu$s and the amplitude of 50.36 kV is formed on the load 6.

By the time $t_3$ = 1.8 $\mu$s, the capacitors 3 of the Marx generator are discharged to the total voltage $U_M = 2 (N_2U_2 + N_2U_d + U_{d1}) - N_1U_1$ = - 80 V.

The energy obtained from the discharge of the Marx capacitors 3 is equal to:

$$E_{IN} = 20 * 112 \text{ nF} * (5.05 \text{ kV} + 80 \text{ V} / 20) 2/2 = 28.6 \text{ J}$$

The voltage on the limiter capacitors 9 during the generation process varied little, that is, the energy changes associated with the limiter capacitors 9 can be neglected.

The energy incoming to the load 6 in the pulse is equal to:

$$E_{OUT} = U_R^2 * t_{pul} / R = 27.9$$

JThus, the efficiency makes 27.9 J / 28.6 J = 97.5%.

In practice, the generator efficiency made slightly over 70%. The difference is due to the fact that the losses in the switches 2 of the Marx generator and the charging circuits 1 and 7 of the Marx generator and the limiter were not taken into account above.

## Claims

1. A high-voltage pulse generator for receiving rectangular voltage pulses, including a charging circuit, a limiter and a load, **characterized in that**, the charging circuit is brought into the Marx generator, also containing $N_1$-links consisting of switches with capacitors, connected in Arkadyev-Marx stage voltage multiplication circuit, with the first-link Marx generator capacitor connected to the common bus, and the charging circuit of the Marx generator connected to the common bus and to the points of connection of the capacitors and switches in each of the $N_1$-links, herewith the choke and the diode with short reverse recovery time are connected in series between the last switch of the Marx generator and the common bus, while the limiter includes a charging circuit and $N_2$-links consisting of drift diodes and capacitors connected in series, with the capacitor of the first link limiter connected to the common bus, and the limiter charging circuit connected to the common bus and to the points of connection of capacitors and drift diodes in each link of the $N_2$-links, herewith the last drift diode of $N_2$-links of the limiter is connected to the point of connection of the load and the pulse diode with short reverse recovery time, while the parameters of the charging circuits of the Marx generator and the limiter and the number of their links $N_1$ and $N_2$ must satisfy the following condition:

$$U_M > 2 (U_o + U_{d1}) \text{ or } N_1U_1 > 2 (N_2U_2 + N_2U_d + U_{d1}),$$

where

$U_M = N_1U_1$ - voltage of the Marx generator;
$N_1$ - the number of links in the Marx generator;
$U_1$ - voltage determined by the Marx generator charging circuit;
$U_o = N_2U_2 + N_2U_d$ - voltage of the limiter;
$N_2$ - the number of links in the limiter;
$U_2$ - voltage determined by the limiter charging circuit;
$U_d$ - voltage drop on the drift diode;
$U_{d1}$ - voltage drop on the pulse diode with short reverse recovery time.

Figure 1

Figure 2a

Figure 2b

Figure 2c

Figure 2d

Figure 2e

## INTERNATIONAL SEARCH REPORT

| | |
|---|---|
| International application No. | |
| PCT/RU 2017/000829 | |

| A. CLASSIFICATION OF SUBJECT MATTER |
|---|
| H03K 3/53 (2006.01) |
| According to International Patent Classification (IPC) or to both national classification and IPC |

| B. FIELDS SEARCHED |
|---|
| Minimum documentation searched (classification system followed by classification symbols) |
| H05K 3/00-3/543 |
| |
| Documentation searched other than minimum documentation to the extent that such documents are included in the fields searched |
| |
| Electronic data base consulted during the international search (name of data base and, where practicable, search terms used) |
| PatSearch (RUPTO internal), USPTO, PAJ, K-PION, Esp@cenet, Information Retrieval System of FIPS |

| C. DOCUMENTS CONSIDERED TO BE RELEVANT |
|---|

| Category* | Citation of document, with indication, where appropriate, of the relevant passages | Relevant to claim No. |
|---|---|---|
| A | US 2007/0139090 A1 (RICHARD L.CASSEL) 21.06.2007 | 1 |
| A | RU 2317637 C1 (ROSSIISKAYA FEDERATSIYA V LITSE FEDERALNOGO AGENSTVA PO ATOMNOI ENERGII et al.) 20.02.2008 | 1 |
| A | US 2008/0191559 A1 (DIEHL BGT DEFENCE GMBH &CO KG) 14.08.2008 | 1 |

| ☐ Further documents are listed in the continuation of Box C. | ☐ See patent family annex. |
|---|---|

| | | |
|---|---|---|
| * Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
|---|---|
| 16 January 2018 (16.01.2018) | 18 January 2018 (18.01.2018) |
| Name and mailing address of the ISA/ | Authorized officer |
| | |
| Facsimile No. | Telephone No. |

Form PCT/ISA/210 (second sheet) (July 1998)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- RU 2102834

- US 3486043 A